## Europäisches Patentamt
## European Patent Office
## Office européen des brevets

(11) Veröffentlichungsnummer: **0 202 623**
**B1**

(12) **EUROPÄISCHE PATENTSCHRIFT**

(45) Veröffentlichungstag der Patentschrift: 02.05.90

(51) Int. Cl.⁵: **C 25 D 5/48, C 25 D 5/02**

(21) Anmeldenummer: **86106694.2**

(22) Anmeldetag: **16.05.86**

(54) Verfahren zur Metallisierung eines Substrates.

(30) Priorität: 24.05.85 DE 3518766

(43) Veröffentlichungstag der Anmeldung:
26.11.86 Patentblatt 86/48

(45) Bekanntmachung des Hinweises auf die
Patenterteilung:
02.05.90 Patentblatt 90/18

(84) Benannte Vertragsstaaten:
AT BE CH DE FR GB IT LI LU NL SE

(56) Entgegenhaltungen:
WO-A-84/01461

(73) Patentinhaber: **Licentia Patent-Verwaltungs-GmbH**
**Theodor-Stern-Kai 1**
**D-6000 Frankfurt/Main 70 (DE)**

(72) Erfinder: **Ostwald, Robert, Dr.-Ing.**
**Hasensteige 8**
**D-7900 Ulm (DE)**

(74) Vertreter: **Schulze, Harald Rudolf, Dipl.-Ing.**
**Licentia Patent-Verwaltungs-GmbH Theodor-Stern-Kai 1**
**D-6000 Frankfurt/Main 70 (DE)**

Courier Press, Leamington Spa, England.

## Beschreibung

Die Erfindung betrifft ein Verfahren zur naßchemischen Metallisierung [—] nach dem Oberbegriff des Patentanspruchs 1.

Substratmaterialien metallischer oder auch nichtmetallischer Natur werden für die unterschiedlichsten Anwendungsfälle zur Verbesserung ihrer Eigenschaften mit Metallschichten versehen. Ein besonders wirtschaftliches Verfahren dafür ist die galvanische Metallabscheidung. Diese kann auf metallischen Substraten in der Regel nach Reinigungsprozessen direkt durchgeführt werden und auf nichtmetallischen — also den elektrischen Strom nicht oder ungenügend leitenden — Oberflächen nach einer meist chemischen Vormetallisierung durchgeführt werden. Diese galvanisch erzeugten Metallschichten müssen eine Reihe verschiedener Beanspruchungen, so z.B. auch thermische Belastungen, bei der Weiterverarbeitung oder auch dem praktischen Einsatz aushalten, ohne sich in ihren Eigenschaften, wie z.B. ihrer Haftfestigkeit auf dem Unterlagematerial, unzulässig zu verändern. Insbesondere die Schichthaftung unterliegt bei thermischer Beanspruchung oft kritischen Belastungen, die sowohl durch mechanische Spannungen zwischen Metallschicht und Unterlage aufgrund unterschiedlicher thermischer Ausdehnungskoeffizienten als auch durch chemische Veränderungen zwischen Metallschicht und Unterlagematerial auftreten können. Gerade bei der galvanischen Metallabscheidung werden mehr oder weniger große Anteile Wasserstoff sowie verschiedene, in der Regel organische Badzusätze bei der Metallabscheidung mit eingelagert und auch Elektrolyt- und/oder Wasserreste können insbesondere bei porigen Unterlagen mit eingebaut werden. Je nach thermischer Behandlung einer solchen Metallschicht können dann die eingelagerten Fremdstoffe durch Ausscheidung, Verdampfung oder Zersetzung einen hohen Gasdruck verursachen, der entweder ohne Zerstörung der Beschichtung z.B. durch Diffusion durch die Metallschicht abgebaut wird oder diese vom Unterlagematerial mehr oder weniger großflächig trennt. In der Regel zeigt eine solche Metallschicht eine größere Anzahl von Blasen, die mit abnehmender Haftfestigkeit größer und zahlreicher werden.

Aus der WO—A—84/01 461 ist ein Verfahren bekannt, Metall, z.B. Stahl galvanisch mit einer weiteren Metallschicht, z.B. Kupfer, zu beschichten. Dabei besitzt die Metallschicht eine durch mikroskopisch kleine Kanäle charakterisierte Mikrostruktur. Durch diese Kanäle können in dem Metall enthaltene Gase, insbesondere Wasserstoff, entweichen, so da eine sogenannte Wasserstoffversprödung des Metals vermieden wird.

Die Haftfestigkeit von galvanisch auf nichtmetallischen Unterlagen abgeschiedenen Metallschichten ist meistens nicht ausreichend hoch, um eine Blasenbildung bei thermischer Belastung durch z.B. Lötprozesse zu verhindern. Deshalb kommen für derartig beanspruchte Metallschichten zu deren Herstellung mesit nur apparativ aufwendige und wenig wirtschaftliche Verfahren wie z.B. die Vakuumaufdampf-, Kathodenzerstäubungs- oder die CVD-Technik in Frage.

Der Erfindung liegt daher die Aufgabe zugrunde, ein gattungsgemäßes Verfahren dahingehend zu verbessern, daß eine möglichst hohe Haftfestigkeit der abgeschiedenen Metallschicht erreicht wird insbesondere bei thermischen Belastungen, die bei Weich- oder Hartlötvorgängen in der Elektroindustrie auftreten.

Diese Aufgabe wird gelöst durch die in Patentanspruch 1 angegebenen Merkmale, Zweckmäßige Ausgestaltungen und/oder Weiterbildungen sind den Unteransprüchen entnehmbar.

Die Erfindung beruht auf der Erkenntnis, daß es in kostengünstiger Weise möglich ist, die Metallschicht derart zu strukturieren, daß bei einer nachfolgenden Wärmebehandlung störende Flüssigkeits- und/oder Gasreste aus der Grenzschicht zwischen der Metallschicht und dem Substrat ausdiffundieren. Bei einer anschließenden thermischen Belastung, z.B. einem Weichlötvorgang bei einer Temperatur von ungefähr 280°C und einer Dauer von ungefähr 20 sec oder einem Hartlötvorgang bei einer Temperatur von ungefähr 400°C und einer Dauer von ungefähr 10 sec tritt dann keine störende Blasenbildung der Metallschicht mehr auf.

Die Erfindung wird anhand von Ausführungsbeispielen näher erläutert:

### Beispiel 1

Aluminiumoxid-Keramiksubstrate (99,5% $Al_2O_3$) mit den Abmessungen $50,8 \times 50,8 \times 0,6$ mm³ werden durch Tauchen in eine NaOH-Schmelze in bekannter Weise von der glasartigen "Brennhaut" befreit und bei Ultraschall-Anregung in demineralisiertem Wasser sorgfältig gespült. Durch aufeinanderfolgende Behandlungen in einer salzsauren Lösung von Zinn-(II)-chlorid, in Wasser und in einer salzsauren Lösung von Palladiumchlorid sowie abschließendem Spülen in Wasser entsteht nach bekanntem Verfahren eine für chemische Metallabscheidungen katalytisch wirkende Keimschicht auf der Keramikoberfläche. Auf dieser wird aus einem derzeit handelsüblichen chemischen Kupferbad ein ungefähr 0,2 µm dicke Kupfer-Basisschicht abgeschieden, die anschließend aus einem derzeit handelsüblichen Kupfersulfatbad auf eine ungefähr 15 µm dicke glänzende Kupferschicht verstärkt wird. Mit Hilfe der bekannten Fotoätztechnik werden auf einer rechteckigen Testfläche von $20 \times 30$ mm² in der Kupferschicht Bohrungen von 50 µm Durchmesser in einem Punkteraster mit 1 mm Abstand durch Sprühätzung hergestellt. Diese Bohrungen mit einem beispielhaften kreisförmigen Querschnitt gehen vollständig durch die Metallschicht hindurch und werden durch das Substrat begrenzt. Nach der Strippung der Fotolackschicht werden die Keramikproben 10 Minuten lang einer Wärmebehandlung ausgesetzt bei einer Temperatur von 430°C sowie einer Stickstoffatmosphäre. Nach Abkühlung auf Raumtemperatur (20°C) wird bei einer Untersuchung der Kupferbeschichtung festgestellt, daß diese außerhalb der 20 × 30 mm² großen Testfläche mit mehreren großen Blasen übersät ist. Schälkraftmessungen in dem perforierten Schichtbereich der Testfläche anhand von fotoätztechnisch hergestellten, 1 mm breiten Kupferstreifen zeigten hohe Trannkräfte von ungefähr 0,5N. In dem übrigen ununterbrochenem Bereich der Kupferschicht erfolgt keine Ausdiffusion der bei der Abscheidung der Metallschicht eingeschlossenen Flüssigkeits- und/oder Gasreste, so daß dort ein teilweises Abl sen der Metallschicht eintritt (Blasenbildung).

Beispiel 2

Aluminiumoxid-Keramkisubstrate werden wie in Beispiel 1 vorbehandelt und mit katalytisch wirksamen Keimen belegt. Auf diese Schicht wird aus einem derzeit handelsüblichen chemischen Nickel-Hypophosphitbad eine ungefähr 0,1 µm dicke Nickel-Phosphorschicht abgeschieden, diese sorgfältig gespült und getrocknet. Mit Hilfe der Fotolacktechnik werden auf der Nickel-Phosphorbasisschicht Fotolackpunkte von ungefähr 100 µm Durchmesser in einem Rasterabstand von 2 mm auf einer Testfläche von 20 × 30 mm² erzeugt. Anschließend wird in einem derzeit handelsüblichen galvanischem Kupfersulfatbad auf eine ungefähr 10 µm dicke Kupferschicht verstärkt. Nach der Strippung der Fotolackpunkte, sorgfältiger Spülung und Trocknung werden auch diese Schichten einer Wärmebehandlung bei 430°C, wie in Beispiel 1, ausgesetzt. Bei einer anschließenden Untersuchung der Metallschicht wird festgestellt, daß diese — außerhalb der Testfläche mit dem Lochraster — von mehreren kleinen Blasen übersät ist. Schälkraftmessungen in dem perforierten Schichtbereich an fotoätztechnisch präparierten Schichtstreifen zeigen sehr gute Haftfestigkeiten von ungefähr 0,7 N/mm.

Die Erfindung ist nicht auf die beschriebenen Ausführungsbeispiel beschränkt, sondern sinngemäß auf weitere anwendbar. Beispielsweise ist es möglich auf das erwähnte Lochraster zu verzichten, wenn die herzustellenden Metallstrukturen, z.B. elektrische Leiterbahnen, lediglich eine Breite besitzen, die kleiner als 2 mm ist. Die Herstellung derartiger Metallstrukturen ist beispielsweise möglich mit sogenannten Additiv- oder Semiadditivverfahren. Bei derartigen Metallstrukturen entweichen bei der erwähnten Wärmebehandlung die störenden Flüssigkeits- und/oder Gasreste ohne Schädigung der Schichten.

Weiterhin ist es beispielsweise möglich, die erwähnten Metallstrukturen durch physikalische Verfahren herzustellen, z.B. durch Fräsen und/oder ein Laser-Bearbeitungsverfahren.

## Patentansprüche

1. Verfahren zur naßchemischen Metallisierung eines elektrisch nichtleitenden Keramiksubstrates, auf das nach einer Reinigung zunächst ein katalytisch wirkende Keimschicht aufgebracht wird, die anschließend metallisiert wird, dadurch gekennzeichnet,

daß bei einem Aluminium-Oxid-Keramiksubstrat auf der Keimschicht eine Basisschicht, die Kupfer oder Nickel-Phospor enthält, abgeschieden wird,

daß darauf eine Metallschicht abgeschieden wird, welche bis auf das Keramiksubstrat hindurchgehende Öffnungen besitzt, so daß Metallstrukturen mit einer Breite kleiner als zwei Millimeter entstehen, und

daß die derart strukturierte Metallschicht anschließend derart erwärmt wird, daß darunter eingeschlossene Gas- und/oder Flüssigkeitsreste an den Öffnungen entweichen.

2. Verfahren nach Anspruch 1, dadurch gekennzeichnet, daß die Öffnungen als Bohrungen mit einem Durchmesser kleiner als einen Millimeter ausgebildet und in Form eines Lochrasters angelegt werden.

3. Verfahren nach einem der vorhergehenden Ansprüche, dadurch gekennzeichnet, daß die Öffnungen während der Abscheidung der Metallschicht, die mit Hilfe eines Additiv- oder Semiadditiv- verfahrens erzeugt wird, gebildet werden.

4. Verfahren nach einem der vorhergehenden Ansprüche, dadurch gekennzeichnet, daß die Metallstrukturen sowie die Öffnungen nach dem Abscheiden der Metallschicht durch fotoätztechnische und/oder physikalische Verfahren hergestellt werden.

## Revendications

1. Procédé de métallisation chimique humide d'un substrat de céramique non conducteur de l'électricité sur lequel, après le nettoyage, on applique d'abord un couche de germes à action catalytique, qui est ensuite métallisée, caractérisé

en ce que, dans le cas d'un substrat de céramique d'oxyde d'aluminium, on dépose sur le couche de germes une couche de base qui contient du cuivre ou du nickel-phosphore,

en ce que l'on dépose par-dessus une couche métallique qui possède des ouvertures la traversant jusqu'au substrat de céramique, de sorte q'uil se forme des structures métalliques d'une largeur de moins de 2 mm, et

en ce que l'on chauffe ensuite la couche métallique structurée de ce type de telle sorte que les restes de gaz et/ou de liquide inclus dessous se dégagent par les ouvertures.

2. Procédé selon la revendication 1, caractérisé en ce que les ouvertures sont formées comme des alésages d'un diamètre de moins de 1 mm et appliquées sous forme d'un réseau de trous.

3. Procédé selon l'une des revendications précédentes, caractérisé en ce que les ouvertures sont formeés pendant le dépôt de la couche métallique qui est produite au moyen d'un procédé à l'additif ou semi-additif.

4. Procédé selon l'une des revendications précédentes, caractérisé en ce que les structures métalliques ainsi que les ouvertures sont fabriquées après le dépôt de la couche métallique par des procédées de photogravure et/ou des procédés physiques.

## Claims

1. Method for the wet chemical metallising of an electrically non-conducting ceramic substrate, onto which a catalytically effective seed layer is initially applied after cleaning and subsequently metallised, characterised thereby,

that in the case of an aluminium oxide ceramic substrate, a base layer containing copper or nickel phosphor is precipitated on the base layer,

that a metal layer is precipitated thereon, which possesses openings passing through to the ceramic substrate so that metal structures with a width of less than two millilmetres arise and

that the metal layer structure in such a manner is subsequently heated in such a manner that residues of gas and/or liquid enclosed thereunder can escape at the openings.

2. Method according to claim 1, characterised thereby, that the openings are formed as bores with a diameter of less than one millimetre and established in the shape of a hole raster.

3. Method according to one of the preceding claims, characterised thereby, that the openings are formed during the precipitation of the metal layer which is produced with the aid of an additive or semi-additive method.

4. Method according to one of the preceding claims, characterised thereby, that the metal structures as well as the openings are produced by photo-etching and/or physical methods after the precipitation of the metal layer.